# EUROPEAN PATENT SPECIFICATION

(11) **EP 4 216 028 B1**
(45) Date of publication and mention of the grant of the patent: **18.11.2026**
(21) Application number: 23150431.7
(22) Date of filing: 05.01.2023
(51) Int. Cl.: G06F 1/18, H01R 13/627, H05K 7/14, G06F 1/186, H01R 13/633

(54) **ELECTRONIC DEVICE WITH AN EXTRACTION DEVICE AND EXTRACTION DEVICE THEREOF**
ELEKTRONISCHE VORRICHTUNG MIT EXTRAKTIONSVORRICHTUNG UND EXTRAKTIONSVORRICHTUNG DAFÜR
DISPOSITIF ÉLECTRONIQUE AVEC UN DISPOSITIF D'EXTRACTION ET DISPOSITIF D'EXTRACTION ASSOCIÉ

(30) Priority: 25.01.2022 US 202263302986 P; 17.11.2022 CN 202211441984
(43) Date of publication of application: 26.07.2023
(73) Proprietor: Getac Technology Corporation, Taipei City 11568 (TW)
(72) Inventor: LEE, Kun-Cheng, Taipei City 11568 (TW)
(74) Representative: Viering, Jentschura & Partner mbB Patent- und Rechtsanwälte

(56) References cited:
- US-A- 5 309 325
- US-B1- 10 340 635

## Description

### FIELD OF THE DISCLOSURE

The present disclosure relates to an electronic device with an extraction device and an extraction device thereof, and more particularly to an extraction device, which is provided with a handle that can be locked to an electronic device or extracted away from the electronic device.

### BACKGROUND OF THE DISCLOSURE

US 10 340 635 B1 discloses a pluggable and unpluggable device and a handle for the same. The pluggable and unpluggable device includes a carrier, a shaft disposed at the carrier, and a handle movably mounted on the shaft and adapted to engage with and pull out, from an apparatus, the pluggable and unpluggable device in an engaged state and a pulled-out state respectively, alternately and repeatedly. The handle includes a handle body, a guide tunnel disposed in the handle body, and an engaging portion disposed on the handle body. The handle body fits around the shaft by the guide tunnel to thereby slide or rotate relative to the shaft. The engaging portion engages with and escapes from the apparatus as the handle body slides relative to the shaft by the guide tunnel. Therefore, the handle is unlikely to sever, capable of being locked and unlocked, one-piece and thus structurally simple, and space-efficient.

Existing electronic devices have peripheral accessories that are designed to be capable of being plugged or unplugged from the device, and are therefore referred to as extraction devices. These extraction devices can be plugged into the electronic devices for use, or can be extracted from the electronic devices for portability. When the extraction device is plugged in the electronic devices, the extraction device is usually submerged completely into the electronic devices.

In order to facilitate removal of the extraction device, a conventional extraction device is provided with a multi-piece handle for the user to hold on to for engage or disengaging the conventional extraction device from the electronic device. Since the handle is a multi-piece design, the structure of the handle is more complex and occupies significant space, sometimes unnecessarily. In addition, such a complex structure may easily lead to malfunctions or inconveniences in operation.

### SUMMARY OF THE DISCLOSURE

In response to the above-referenced technical inadequacies, the present disclosure provides an extraction device according to claim 1. The dependent claims show further embodiments of claim 1.

In one aspect, the present disclosure provides an extraction device, that is detachably disposed in an electronic device, the extraction device comprising: a housing having a front side that has two ends, one of the two ends including a pivot, and another one of the two ends including a limiting member, wherein the limiting member has at least one limiting recessed portion that is formed along a sliding direction; a handle having a draw bar and a hook, the draw bar having a pivot end and an operation end, the pivot end of the draw bar having a long groove that is formed along a longitudinal direction of the draw bar, and a pulling and gripping portion being formed on the operation end of the draw bar, wherein the pulling and gripping portion is connected to the hook, the pivot of the housing is disposed in the long groove of the draw bar, and a bottom portion of the hook is configured to be engaged into the at least one limiting recessed portion of the housing along the sliding direction to be in an engaged state; wherein a front end of the hook is configured to be simultaneously blocked at an inner edge of a notch of a main body of an electronic device in the engaged state when the extraction device is detachably disposed in a receiving groove of the main body of the electronic device, so that the hook is configured to fix the extraction device in the notch, wherein the notch serves as an entrance and an exit of the receiving groove; wherein the handle is configured to slide for a straight-line distance along an unlocking direction, so that the hook in the engaged state departs from the at least one limiting recessed portion to be in an unengaged state.

In response to the above-referenced technical inadequacies, the present disclosure provides an electronic device with an extraction device according to claim 13.

In aspect, the present disclosure provides an electronic device with an extraction device. The electronic device includes a main body and an extraction device. The main body has a receiving groove and a notch. The extraction device is detachably disposed in the receiving groove and includes a housing and a handle. A front side of the housing has two ends, one of the two ends has a pivot, and another one of the two ends has a limiting member. The limiting member has at least one limiting recessed portion that is formed along a sliding direction. The handle has a draw bar and a hook. The draw bar has a pivot end and an operation end, the pivot end of the draw bar has a long groove that is formed along a longitudinal direction of the draw bar, and a pulling and gripping portion is formed on the operation end of the draw bar. The pulling and gripping portion is connected to the hook, the pivot of the housing is disposed in the long groove of the draw bar, and the hook is configured to be engage into the at least one limiting recessed portion along the sliding direction to be in an engaged state and blocked at an inner edge of the notch. The handle is configured to slide for a straight-line distance along an unlocking direction, so that the hook in the engaged state departs from the at least one limiting recessed portion to be in an unengaged state.

Therefore, in the electronic device and the extraction device thereof provided by the present disclosure, by virtue of "the handle having a draw bar and a hook, a pulling and gripping portion being formed on the operation end of the draw bar, and the pulling and gripping portion being connected to the hook" and "the handle being configured to slide for a straight-line distance along an unlocking direction, so that the hook in the engaged state departs from the at least one limiting recessed portion to be in an unengaged state," the extraction device can provide a convenient and sturdy handle to increase the convenience of operation. The handle integrates the draw and the hook into a one-piece structure, and the handle also has the function of a latch. During the unlocking process, the hook departs from the housing and a casing of the electronic device along with the handle, so as to prevent the hook from being damaged by collision against the casing.

These and other aspects of the present disclosure will become apparent from the following description of the embodiment taken in conjunction with the following drawings and their captions, although variations and modifications therein may be affected without departing from the claim scope.

### BRIEF DESCRIPTION OF THE DRAWINGS

The described embodiments may be better understood by reference to the following description and the accompanying drawings, in which:
FIG. 1 is a schematic perspective view of an extraction device according to the present disclosure;
FIG. 2 is a partial exploded view of the extraction device according to the present disclosure;
FIG. 3 is another partial exploded view of the extraction device according to the present disclosure;
FIG. 4 is a partial enlarged view of the extraction device according to the present disclosure;

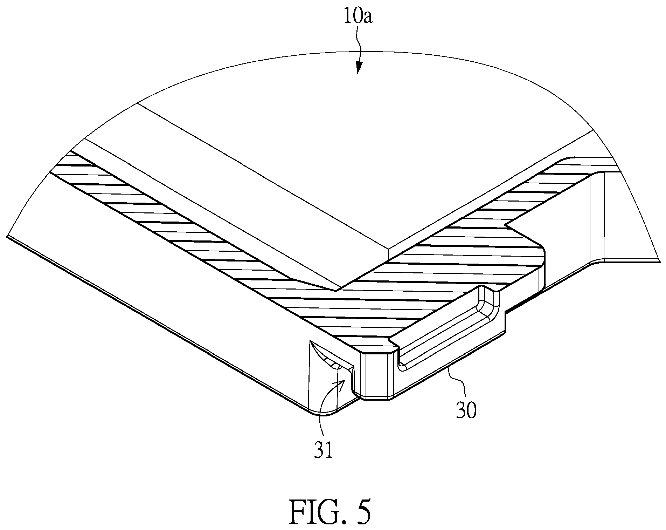

FIG. 5 is a partial enlarged view of a limiting member of the extraction device according to the present disclosure;
FIG. 6 is a schematic cross-sectional view of the extraction device in an engaged state and located in an electronic device according to the present disclosure;
FIG. 7 is a schematic cross-sectional view of the extraction device in an unengaged state and located in the electronic device according to the present disclosure;
FIG. 8 is a schematic cross-sectional view of a handle of the extraction device rotated outward according to the present disclosure; and
FIG. 9 is a schematic cross-sectional view of the extraction device extracted out from the electronic device according to the present disclosure.

### DETAILED DESCRIPTION OF THE DISCLOSURE

The present disclosure is more particularly described in the following examples that are intended as illustrative only since numerous modifications and variations therein will be apparent to those skilled in the art. Like numbers in the drawings indicate like components throughout the views. As used in the description herein and throughout the claims that follow, unless the context clearly dictates otherwise, the meaning of "a", "an", and "the" includes plural reference, and the meaning of "in" includes "in" and "on". Titles or subtitles can be used herein for the convenience of a reader, which shall have no influence on the scope of the present disclosure.

The terms used herein generally have their ordinary meanings in the art. In the case of conflict, the present document, including any definitions given herein, will prevail. The same thing can be expressed in more than one way. Alternative language and synonyms can be used for any term(s) discussed herein, and no special significance is to be placed upon whether a term is elaborated or discussed herein. A recital of one or more synonyms does not exclude the use of other synonyms. The use of examples anywhere in this specification including examples of any terms is illustrative only, and in no way limits the scope and meaning of the present disclosure or of any exemplified term. Likewise, the present disclosure is not limited to various embodiments given herein. Numbering terms such as "first", "second" or "third" can be used to describe various components, signals or the like, which are for distinguishing one component/signal from another one only, and are not intended to, nor should be construed to impose any substantive limitations on the components, signals or the like.

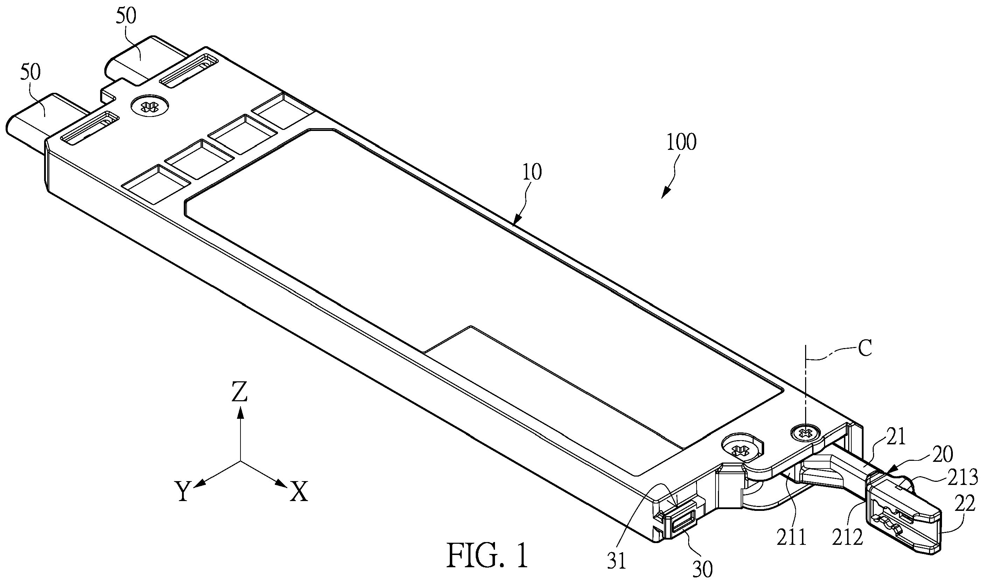

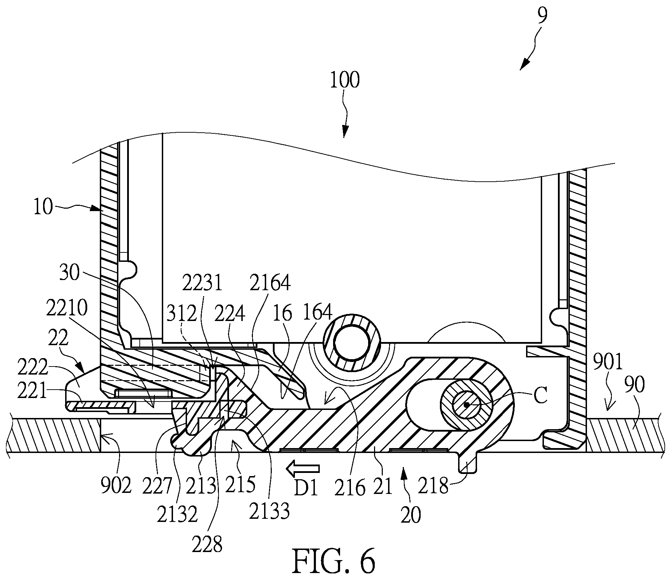

Referring to FIG. 1 to FIG. 4, the present disclosure provides an electronic device with an extraction device. The electronic device 9 (as shown in FIG. 6) includes a main body 90, and the main body 90 has a receiving groove 901 and a notch 902. The extraction device 100 is detachably disposed in the receiving groove 901, and the notch 902 serves as an entrance and an exit of the receiving groove 901. For example, the electronic device 9 in the present embodiment can be, for example, a notebook computer, a tablet computer, or an industrial computer, but the present disclosure is not limited thereto.

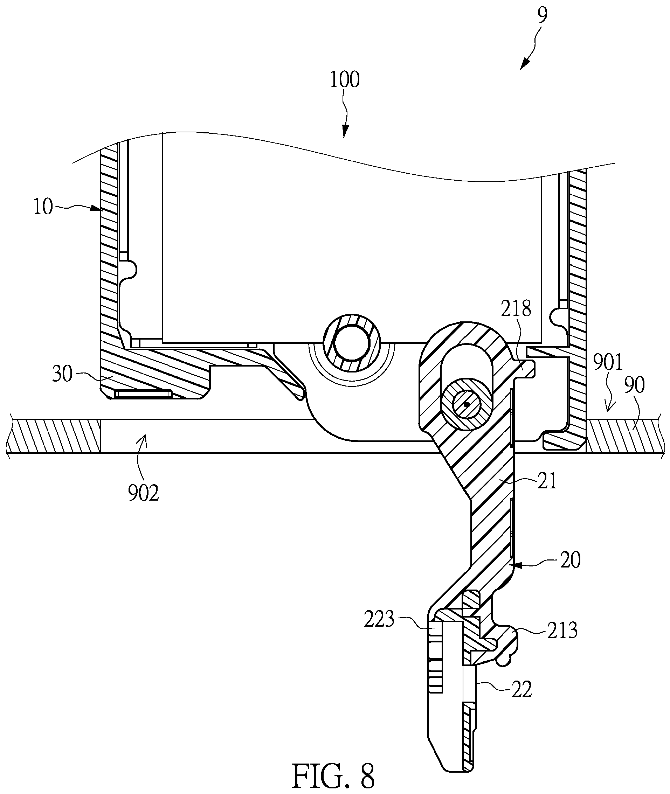

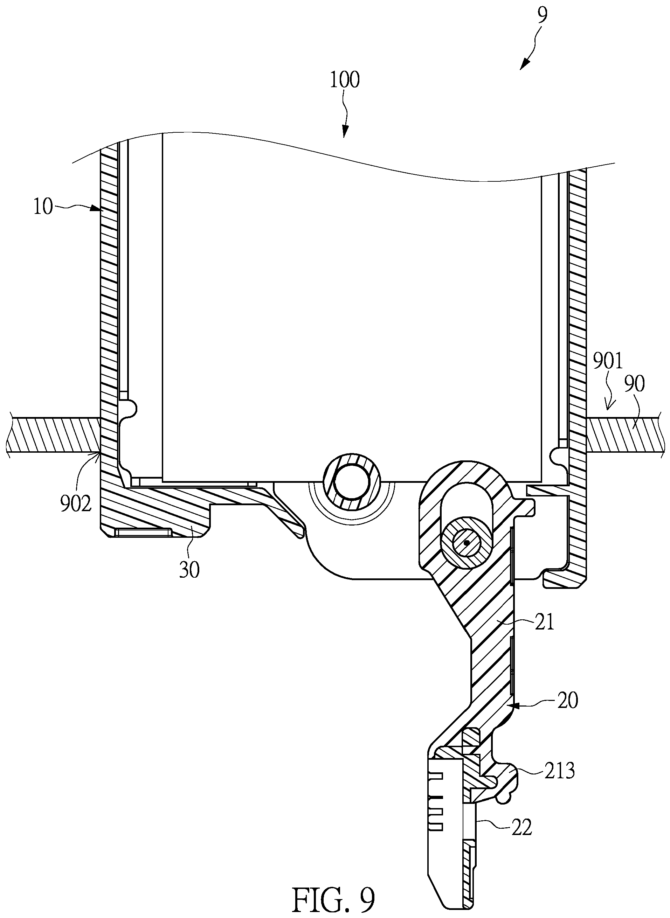

The extraction device 100 is detachably disposed in the receiving groove 901 of the electronic device 9 (as shown in FIG. 8 and FIG. 9) along an extraction direction (e.g., an X-axis direction in FIG. 1). In the present embodiment, the extraction direction is a direction away from the electronic device 9, and is also a longitudinal direction of the electronic device 9.

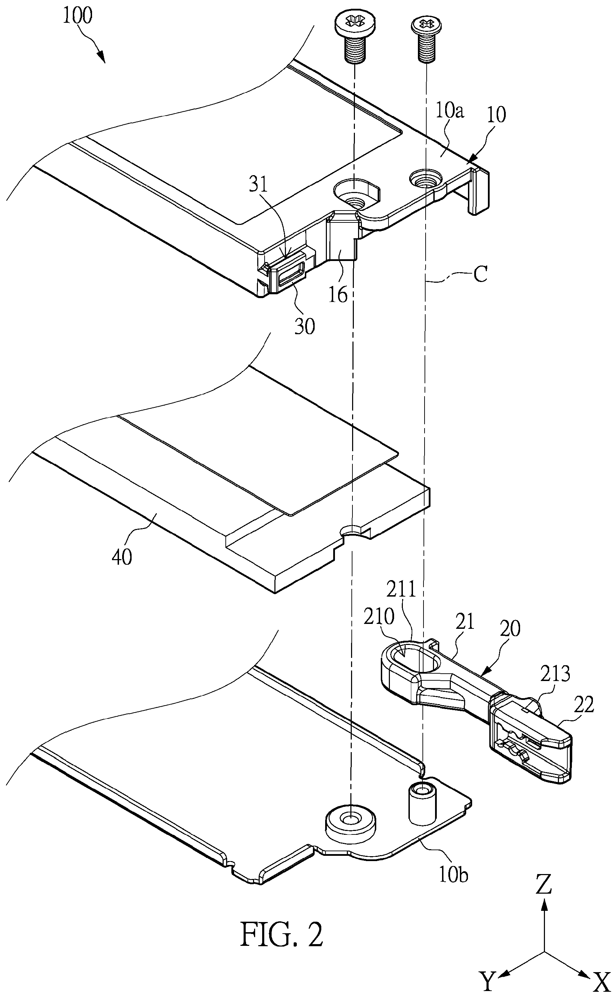

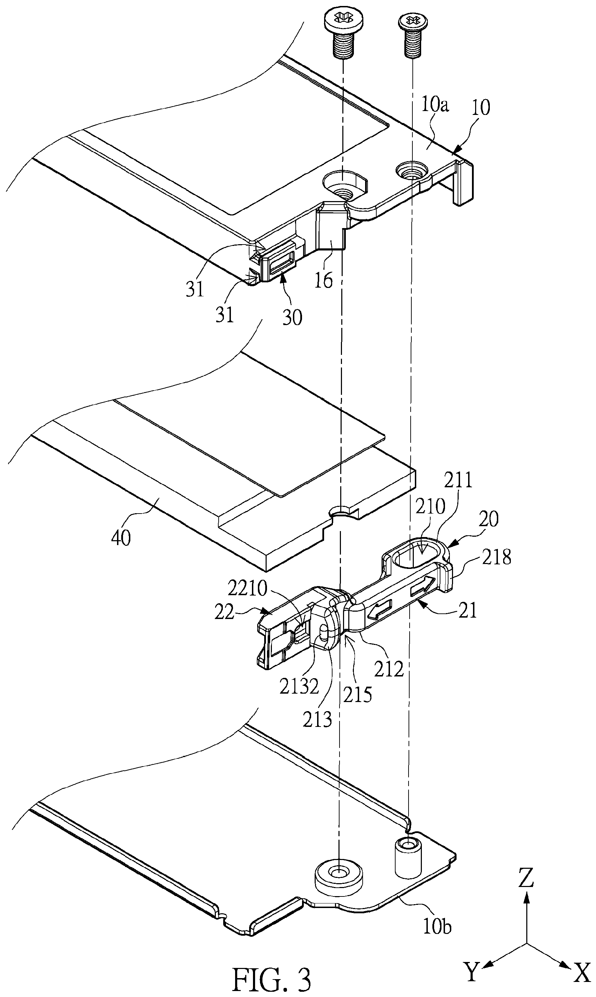

Referring to FIG. 2 and FIG. 3, the extraction device 100 includes a housing 10 and a handle 20. A front side of the housing 10 has two ends, one of the two ends has a pivot C, and another one of the two ends has a limiting member 30. The housing 10 in the present embodiment is formed by connecting an upper casing 10a and a lower casing 10b to each other. The limiting member 30 has at least one limiting recessed portion 31 that is formed along a sliding direction (e.g., a Y-axis direction in FIG. 1, and a sliding direction D1 in FIG. 6). In the present embodiment, each of both sides of the limiting member 30 has a limiting recessed portion 31. In other words, the limiting recessed portion 31 is perpendicular to the extraction direction of the extraction device 100, so that the limiting member 30 can limit the movement of the handle 20 in the extraction direction.

For example, the extraction device 100 in the present embodiment may be a removable storage device. Referring to FIG. 1, a storage unit 40 is accommodated inside the housing 10, and the storage unit 40 is, for example, a memory or a hard disk, but the present disclosure is not limited thereto. A rear side of the extraction device 100 has two connectors 50 that are electrically connected to the electronic device 9 to transmit data or signals, but the present disclosure is not limited thereto.

Referring to FIG. 1 and FIG. 3, the handle 20 has a draw bar 21 and a hook 22. The draw bar 21 has a pivot end 211 and an operation end 212. The pivot end 211 of the draw bar 21 has a long groove 210 that is formed along a longitudinal direction of the draw bar 21. A pulling and gripping portion 213 is formed on the operation end 212 of the draw bar 21, and is connected to the hook 22. An operator can hold the pulling and gripping portion 213 to operate the handle 20, which makes it easier for the operator to apply force. The pivot C of the housing 10 is disposed in the long groove 210 of the draw bar 21, and the hook 22 is configured to be engage into the limiting recessed portions 31 along the sliding direction (e.g., a Y-axis direction in FIG. 1, and a sliding direction D1 in FIG. 6) to be in an engaged state (as shown in FIG. 6). At the same time, the hook 22 is blocked at an inner edge of the notch 902 of the electronic device 9. Thereby, the extraction device 100 is blocked and fixed inside the receiving groove 901 of the electronic device 9.

In the present embodiment, a material of the hook 22 is different from that of the draw bar 21. The draw bar 21 is made of an elastic material, the hook 22 is made of a rigid material, and the hook 22 is integrally connected to the draw bar 21. For example, the draw bar 21 and the hook 22 can be manufactured by double-material injection molding to form a one-piece structure. The advantage of the above arrangement of materials is that the draw bar 21 has elasticity and can be operated more comfortably by the operator, and the elasticity of the draw bar 21 can prevent a breakage of a rotating shaft caused by improper operation. The hook 22 has rigidity and can be firmly engaged with the limiting member 30. The structural strength of the hook 22 is strong and can be used as a lock to be fixed in the notch 902 of the electronic device 9.

Referring to FIG. 3, in the present embodiment, in order for the operator to conveniently hold the handle 20, the draw bar 21 has a finger-accommodating groove 215 that is formed on one of two sides of the pulling and gripping portion 213, and the draw bar 21 has an anti-slip protrusion 2132 that is formed on another one of the two sides of the pulling and gripping portion 213. The finger-accommodating groove 215 can be used for one of fingers to easily exert force on the draw bar 21, and the anti-slip protrusion 2132 further provides a non-slip function for another one of the fingers to exert more force on the handle 20, especially when the force is applied along an unlocking direction D2.

Referring to FIG. 6, the present embodiment can strengthen a bonding strength between the draw bar 21 and the hook 22. The hook 22 has an upper protruding portion 227 facing the pulling and gripping portion 213. The upper protruding portion 227 may be, for example, in a plate shape or a columnar shape. In the present embodiment, the pulling and gripping portion 213 can cover the upper protruding portion 227 through the double-material injection molding technology. A connecting hole 228 is formed on a rear end of the hook 22, and the connecting hole 228 is, for example, a cylindrical hole. Moreover, a bottom of the pulling and gripping portion 213 has a lower protruding portion that is formed toward the hook 22 through the double-material injection molding technology, so that the lower protruding portion 2133 extends into the connecting hole 228. Accordingly, an inside of the draw bar 21 and the hook 22 are engaged with each other, so that a bonding strength of the structure is stronger.

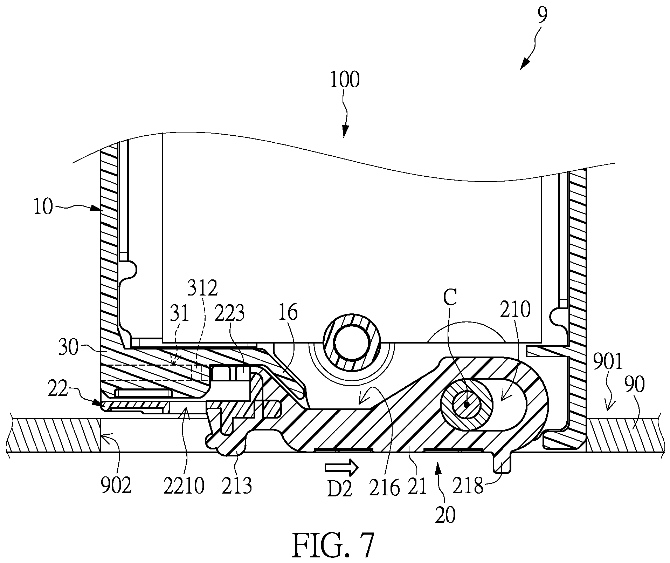

Referring to FIG. 7, the handle 20 can slide for a straight-line distance along an unlocking direction D2 (i.e., a negative Y-axis direction in FIG. 1 and FIG. 3) opposite to the sliding direction D1, so that the hook 22 in the engaged state departs from the limiting recessed portions 31 of the limiting member 30 to be in an unengaged state (as shown in FIG. 7). The straight-line distance can be determined by the length of the long groove 210. Then, the handle 20 can be turned over along the pivot C, and the hook 22 can be kept away from the front side of the housing 10.

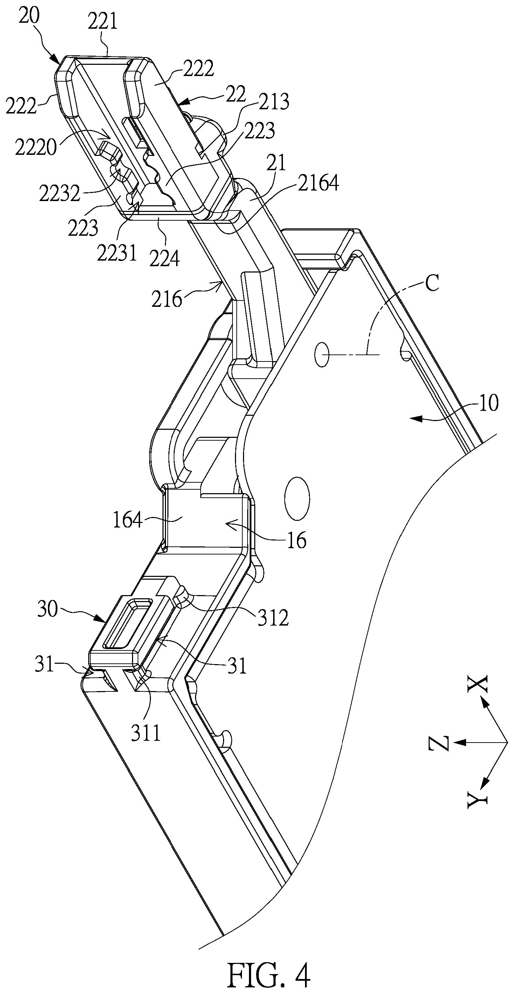

Referring to FIG. 4, the draw bar 21 further has a positioning groove 216 that is formed between the long groove 210 and the pulling and gripping portion 213 of the draw bar 21. The housing 10 can correspondingly have a block part 16, and the block part 16 can block movement of the draw bar 21, so that the draw bar 21 is in the unengaged state (as shown in FIG. 7, otherwise referred to as an unlocked state). Accordingly, when the operator feels that the handle 20 is blocked by the block part 16, the operator can know that the handle 20 has left the limiting member 30.

Referring to FIG. 4, FIG. 6, and FIG. 7, the block part 16 has a blocking bevel 164, the positioning groove 216 has a positioning bevel 2164, and the positioning bevel 2164 is close to the hook 22. When the hook 22 changes from the engaged state to the unengaged state, the blocking bevel 164 abuts against the positioning bevel 2164. In other words, when the handle 20 slides along the unlocking direction D2 until the positioning bevel 2164 abuts against the block part 16, the hook 22 of the handle 20 is in the unlocked state.

Referring to FIG. 4, the following description describes further details of the hook 22. The hook 22 has a top wall 221, a pair of side walls 222, and a rear wall 224. The pair of side walls 222 is connected to two sides of the top wall 221. The rear wall 224 is connected to the rear end of the pair of side walls 222 and is close to the draw bar 21. Each of bottoms of the pair of side walls 222 has an inner rail 223 that extends inward, and each of inner sides of the pair of side walls 222 is recessed to form a guide groove 2220. Specifically, the guide groove 2220 is located between the inner rail 223 and the top wall 221. Moreover, each of both sides of the limiting member 30 of the housing 10 has a limiting recessed portion 31, and the inner rail 223 can be slidably disposed in the limiting recessed portion 31. When the hook 22 is in the engaged state, the rear wall 224 abuts against the limiting member 30. When the inner rail 223 slides into the limiting recessed portion 31 of the limiting member 30, the handle 20 can be prevented from being displaced outwardly in the extraction direction. That is, the handle 20 is prevented from moving in the X-axis direction of FIG. 1 and FIG. 4.

In addition, as shown in FIG. 3, an observation window 2210 is formed on the top wall 221 of the hook 22, and a top portion of the limiting member 30 is exposed from the observation window 2210. In other words, different positions of the limiting member 30 can be seen through the observation window 2210. Accordingly, the operator can easily observe whether the handle 20 is in the engaged state, or has completely reached the unengaged state.

Referring to FIG. 4, the limiting recessed portion 31 further has a front blocking convex portion 311 and a rear blocking convex portion 312, the front blocking convex portion 311 is close to one of two ends of the limiting recessed portion 31, and the rear blocking convex portion 312 is close to another one of the two ends of the limiting recessed portion31. Moreover, the inner rail 223 has a first positioning recessed hole 2231 and a second positioning recessed hole 2232, and the second positioning recessed hole 2232 is located in front of the first positioning recessed hole 2231. That is to say, the second positioning recessed hole 2232 is close to a free end of the hook 22.

Referring to FIG. 6, when the hook 22 is in the engaged state, the rear blocking convex portion 312 of the limiting member 30 is engaged into the first positioning recessed hole 2231 of the hook 22, so as to prevent the handle 20 from sliding. When the operator unlocks the hook 22, a tactile feedback can be provided by cooperation between the second positioning recessed hole 2232 and the rear blocking convex portion 312.

Referring to FIG. 7, when the hook 22 is in the unengaged state, the inner rail 223 of the hook 22 is completely separated from the limiting recessed portion 31 backwards. That is to say, the hook 22 is separated from the rear blocking convex portion 312 and is no longer restricted from moving, and the handle 20 can be freely turned outwards.

Referring to FIG. 7 and FIG. 8, the draw bar 21 has a rotation positioning block 218, and the rotation positioning block 218 protrudes outward from a top surface of the pivot end 211 (as shown in FIG. 1). When the operator continues to push the rotation positioning block 218 backward along the unlocking direction D2, the draw bar 21 can be turned over a predetermined angle (e.g., the predetermined angle in the present embodiment is 90 °) along the pivot C, so that the hook 22 is away from the front side of the housing 10 and the operator can pull the handle 20 (or the draw bar 21) to extract the extraction device 100 from the electronic device 9. It is worth noting that the rotation positioning block 218 has another auxiliary function, and the another auxiliary function is that the rotation positioning block 218 can be blocked on the housing 10 when the draw bar 21 rotates along the pivot C by the predetermined angle, so as to prevent the draw bar 21 from being over-rotated (as shown in FIG. 8).

Referring to FIG. 9, the longitudinal direction of the handle 20 is parallel to the extraction direction, which is convenient for the operator to pull out the extraction device 100 from the notch 902 of the electronic device 9, allowing the extraction device 100 to departs from the receiving groove 901 of the main body 90. At this time, the hook 22 in the present embodiment is located at the front end of the handle 20 and has completely left the limiting member 30, such that the hook 22 will not be accidentally hit by the notch 902 of the electronic device 9.

### [Beneficial Effects of the Embodiment]

In conclusion, in the electronic device and the extraction device thereof provided by the present disclosure, by virtue of "the handle having a draw bar and a hook, a pulling and gripping portion being formed on the operation end of the draw bar, and the pulling and gripping portion being connected to the hook" and "the handle being configured to slide for a straight-line distance along an unlocking direction, so that the hook in the engaged state departs from the at least one limiting recessed portion to be in an unengaged state," the extraction device can provide a convenient and sturdy handle to increase the convenience of operation. The handle integrates the draw and the hook into a one-piece structure, and the handle also has the function of a latch. During the unlocking process, the hook departs from the housing and a casing of the electronic device along with the handle, so as to prevent the hook from being damaged by collision against the casing.

The foregoing description of the exemplary embodiments of the disclosure has been presented only for the purposes of illustration and description and is not intended to be exhaustive or to limit the disclosure to the precise forms disclosed. Many modifications and variations are possible in light of the above teaching.

The embodiments were chosen and described in order to explain the principles of the disclosure and their practical application so as to enable others skilled in the art to utilize the disclosure and various embodiments and with various modifications as are suited to the particular use contemplated. Alternative embodiments will become apparent to those skilled in the art to which the present disclosure pertains without departing from the claim scope.

## Claims

1. An extraction device (100), comprising:
a housing (10) having a front side that has two ends, one of the two ends including a pivot (C), and another one of the two ends including a limiting member (30), wherein the limiting member (30) has at least one limiting recessed portion (31) that is formed along a sliding direction (D1);
a handle (20) having a draw bar (21) and a hook (22), the draw bar (21) having a pivot end (211) and an operation end (212), the pivot end (211) of the draw bar (21) having a long groove (210) that is formed along a longitudinal direction of the draw bar (21), and a pulling and gripping portion (213) being formed on the operation end (212) of the draw bar (21), wherein the pulling and gripping portion (213) is connected to the hook (22), the pivot (C) of the housing (10) is disposed in the long groove (210) of the draw bar (21), and a bottom portion of the hook (22) is configured to be engaged into the at least one limiting recessed portion (31) of the housing (10) along the sliding direction (D1) to be in an engaged state;
wherein a front end of the hook (22) is configured to be simultaneously blocked at an inner edge of a notch (902) of a main body (90) of an electronic device (9) in the engaged state when the extraction device (100) is detachably disposed in a receiving groove (901) of the main body (90) of the electronic device (9), so that the hook (22) is configured to fix the extraction device (100) in the notch (902), wherein the notch (902) serves as an entrance and an exit of the receiving groove (901);
wherein the handle (20) is configured to slide for a straight-line distance along an unlocking direction (D2), so that the hook (22) in the engaged state departs from the at least one limiting recessed portion (31) to be in an unengaged state.

2. The extraction device (100) according to claim 1, wherein the draw bar (21) is made of an elastic material, and a material of the hook (22) is different from that of the draw bar (21), and wherein the hook (22) is integrally connected to the draw bar (21).

3. The extraction device (100) according to claims 1 or 2, wherein the hook (22) has an upper protruding portion (227) facing the pulling and gripping portion (213), and the pulling and gripping portion (213) covers the upper protruding portion (227); wherein a connecting hole (228) is formed on a rear end of the hook (22), a bottom of the pulling and gripping portion (213) has a lower protruding portion (2133) that extends toward the hook (22), and the lower protruding portion (2133) extends into the connecting hole (228).

4. The extraction device (100) according to one of claims 1-3, wherein the draw bar (21) has a finger-accommodating groove (215) that is formed on one of two sides of the pulling and gripping portion (213), and the draw bar (21) has an anti-slip protrusion (2132) that is formed on another one of the two sides of the pulling and gripping portion (213).

5. The extraction device (100) according to one of claims 1-4, wherein the draw bar (21) has a positioning groove (216) that is formed between the long groove (210) and the pulling and gripping portion (213) of the draw bar (21); wherein the housing (10) has a block part (16), and the block part (16) is configured to block the draw bar (21), so that the draw bar (21) is in the engaged state or the unengaged state.

6. The extraction device (100) according to one of claims 1-5, wherein the block part (16) has a blocking bevel (164), the positioning groove (216) has a positioning bevel (2164), and the positioning bevel (2164) is close to the hook (22); wherein, when the hook (22) changes from the engaged state to the unengaged state, the blocking bevel (164) abuts against the positioning bevel (2164).

7. The extraction device (100) according to one of claims 1-6, wherein the hook (22) has a top wall (221) and a pair of side walls (222), each of bottoms of the pair of side walls (222) has an inner rail (223) that extends inward, and each of inner sides of the pair of side walls (222) is recessed to form a guide groove (2220) that is located between the inner rail (223) and the top wall (221); wherein each of both sides of the limiting member (30) of the housing (10) has one of the at least one limiting recessed portion (31), and the inner rail (223) is configured to be slidably disposed in the limiting recessed portion (31).

8. The extraction device (100) according to claim 7, wherein the hook (22) has a rear wall (224); wherein, when the hook (22) is in the engaged state, the rear wall (224) abuts against the limiting member (30).

9. The extraction device (100) according to one of claims 7 or 8, wherein an observation window (2210) is formed on the top wall (221) of the hook (22), and a top portion of the limiting member (30) is exposed from the observation window (2210).

10. The extraction device (100) according to one of claims 7 or 8, wherein the limiting recessed portion (31) has a front blocking convex portion (311) and a rear blocking convex portion (312), the front blocking convex portion (311) is close to one of two ends of the limiting recessed portion (31), and the rear blocking convex portion (312) is close to another one of the two ends of the limiting recessed portion (31); wherein the inner rail (223) has a first positioning recessed hole (2231) and a second positioning recessed hole (2232).

11. The extraction device (100) according to claim 10, wherein the second positioning recessed hole (2232) is located in front of the first positioning recessed hole (2231); wherein, when the hook (22) is in the engaged state, the rear blocking convex portion (312) is engaged into the first positioning recessed hole (2231) of the hook (22).

12. The extraction device (100) according to one of claims 1-11, wherein the draw bar (21) has a rotation positioning block (218), and the rotation positioning block (218) protrudes outward from a top surface of the pivot end (211); wherein, when the draw bar (21) is turned over a predetermined angle along the pivot (C), the draw bar (21) is blocked on the housing (10).

13. An electronic device (9) with an extraction device (100) as claimed in any one of claims 1 to 12, **characterized by** comprising:
the main body (90) having the receiving groove (901), and the notch (902); and
the extraction device (100) detachably disposed in the receiving groove (901).

## Patentansprüche

1. Extraktionsvorrichtung (100), aufweisend:
ein Gehäuse (10) aufweisend eine Vorderseite, die zwei Enden hat, wobei eines der zwei Enden einen Drehpunkt (C) aufweist und ein anderes der zwei Enden ein Begrenzungselement (30) aufweist, wobei das Begrenzungselement (30) mindestens einen Begrenzungsvertiefungsabschnitt (31) aufweist, der entlang einer Verschieberichtung (D1) ausgebildet ist;
einen Griff (20) aufweisend eine Zugstange (21) und einen Haken (22), wobei die Zugstange (21) ein Dreh-Ende (211) und ein Betätigungsende (212) hat, wobei das Dreh-Ende (211) der Zugstange (21) eine Langnut (210) hat, die entlang einer Längsrichtung der Zugstange (21) ausgebildet ist, und an dem Betätigungsende (212) der Zugstange (21) ein Zug- und Greifabschnitt (213) ausgebildet ist, wobei der Zug- und Greifabschnitt (213) mit dem Haken (22) verbunden ist, wobei der Drehpunkt (C) des Gehäuses (10) in der Langnut (210) der Zugstange (21) angeordnet ist und ein unterer Abschnitt des Hakens (22) konfiguriert ist, um entlang der Verschieberichtung (D1) in den mindestens einen Begrenzungsvertiefungsabschnitt (31) des Gehäuses (10) einzugreifen, um in einem Eingriffszustand zu sein;
wobei ein vorderes Ende des Hakens (22) konfiguriert ist, um im Eingriffszustand gleichzeitig an einem Innenrand einer Einkerbung (902) eines Hauptkörpers (90) einer elektronischen Vorrichtung (9) blockiert zu sein, wenn die Extraktionsvorrichtung (100) lösbar in einer Aufnahmenut (901) des Hauptkörpers (90) der elektronischen Vorrichtung (9) angeordnet ist, so dass der Haken (22) konfiguriert ist, um die Extraktionsvorrichtung (100) in der Einkerbung (902) zu fixieren, wobei die Einkerbung (902) als ein Eingang und ein Ausgang der Aufnahmenut (901) dient;
wobei der Griff (20) konfiguriert ist, um sich über eine geradlinige Strecke entlang einer Entriegelungsrichtung (D2) zu verschieben, so dass sich der Haken (22) im Eingriffszustand von dem mindestens einen Begrenzungsvertiefungsabschnitt (31) entfernt, um in einem Nichteingriffszustand zu sein.

2. Extraktionsvorrichtung (100) gemäß Anspruch 1, wobei die Zugstange (21) aus einem elastischen Material hergestellt ist und ein Material des Hakens (22) von dem der Zugstange (21) verschieden ist, und wobei der Haken (22) einstückig mit der Zugstange (21) verbunden ist.

3. Extraktionsvorrichtung (100) gemäß den Ansprüchen 1 oder 2, wobei der Haken (22) einen oberen Vorsprungsabschnitt (227) hat, der dem Zug- und Greifabschnitt (213) zugewandt ist, und der Zug- und Greifabschnitt (213) den oberen Vorsprungsabschnitt (227) bedeckt, wobei an einem hinteren Ende des Hakens (22) ein Verbindungsloch (228) ausgebildet ist, ein unterer Teil des Zug- und Greifabschnitts (213) einen unteren Vorsprungsabschnitt (2133) hat, der sich in Richtung zu dem Haken (22) erstreckt, und sich der untere Vorsprungsabschnitt (2133) in das Verbindungsloch (228) erstreckt.

4. Extraktionsvorrichtung (100) gemäß einem der Ansprüche 1 bis 3, wobei die Zugstange (21) eine Fingeraufnahmenut (215) hat, die an einer von zwei Seiten des Zug- und Greifabschnitts (213) ausgebildet ist, und die Zugstange (21) einen rutschfesten Vorsprung (2132) hat, der an einer anderen der zwei Seiten des Zug- und Greifabschnitts (213) ausgebildet ist.

5. Extraktionsvorrichtung (100) gemäß einem der Ansprüche 1 bis 4, wobei die Zugstange (21) eine Positioniernut (216) hat, die zwischen der Langnut (210) und dem Zug- und Greifabschnitt (213) der Zugstange (21) ausgebildet ist; wobei das Gehäuse (10) einen Blockteil (16) hat und der Blockteil (16) konfiguriert ist, um die Zugstange (21) zu blockieren, so dass die Zugstange (21) im Eingriffszustand oder im Nichteingriffszustand ist.

6. Extraktionsvorrichtung (100) gemäß einem der Ansprüche 1 bis 5, wobei der Blockteil (16) eine Blockierfase (164) hat, die Positioniernut (216) eine Positionierfase (2164) hat und die Positionierfase (2164) nahe beim Haken (22) ist; wobei, wenn der Haken (22) vom Eingriffszustand in den Nichteingriffszustand wechselt, die Blockierfase (164) an die Positionierfase (2164) anstößt.

7. Extraktionsvorrichtung (100) gemäß einem der Ansprüche 1 bis 6, wobei der Haken (22) eine obere Wand (221) und ein Paar von Seitenwänden (222) hat, wobei jeder von unteren Teilen des Paares von Seitenwänden (222) eine sich nach innen erstreckende Innenschiene (223) hat und jede von Innenseiten des Paares von Seitenwänden (222) vertieft ist, um eine Führungsnut (2220) auszubilden, die sich zwischen der Innenschiene (223) und der oberen Wand (221) befindet; wobei jede von zwei Seiten des Begrenzungselements (30) des Gehäuses (10) einen von dem mindestens einen Begrenzungsvertiefungsabschnitt (31) hat und die Innenschiene (223) konfiguriert ist, um verschiebbar in dem Begrenzungsvertiefungsabschnitt (31) angeordnet zu sein.

8. Extraktionsvorrichtung (100) gemäß Anspruch 7, wobei der Haken (22) eine Rückwand (224) hat, wobei, wenn der Haken (22) im Eingriffszustand ist, die Rückwand (224) an das Begrenzungselement (30) anstößt.

9. Extraktionsvorrichtung (100) gemäß einem der Ansprüche 7 oder 8, wobei an der oberen Wand (221) des Hakens (22) ein Sichtfenster (2210) ausgebildet ist und ein oberer Abschnitt des Begrenzungselements (30) aus dem Sichtfenster (2210) freiliegt.

10. Extraktionsvorrichtung (100) gemäß einem der Ansprüche 7 oder 8, wobei der Begrenzungsvertiefungsabschnitt (31) einen vorderen blockierenden konvexen Abschnitt (311) und einen hinteren blockierenden konvexen Abschnitt (312) hat, wobei sich der vordere blockierende konvexe Abschnitt (311) nahe bei einem von zwei Enden des Begrenzungsvertiefungsabschnitts (31) befindet und der hintere blockierende konvexe Abschnitt (312) nahe bei einem anderen der zwei Enden des Begrenzungsvertiefungsabschnitts (31) ist; wobei die Innenschiene (223) ein erstes Positioniervertiefungsloch (2231) und ein zweites Positioniervertiefungsloch (2232) aufweist.

11. Extraktionsvorrichtung (100) gemäß Anspruch 10, wobei sich das zweite Positioniervertiefungsloch (2232) vor dem ersten Positioniervertiefungsloch (2231) befindet; wobei, wenn sich der Haken (22) im Eingriffszustand befindet, der hintere blockierende konvexe Abschnitt (312) in das erste Positioniervertiefungsloch (2231) des Hakens (22) eingreift.

12. Extraktionsvorrichtung (100) gemäß einem der Ansprüche 1 bis 11, wobei die Zugstange (21) einen Drehpositionierungsblock (218) hat und der Drehpositionierungsblock (218) von einer oberen Fläche des Dreh-Endes (211) nach außen hervorsteht; wobei, wenn die Zugstange (21) um einen vorbestimmten Winkel entlang des Drehpunktes (C) gedreht wird, die Zugstange (21) am Gehäuse (10) blockiert wird.

13. Elektronische Vorrichtung (9) mit einer Extraktionsvorrichtung (100) gemäß irgendeinem der Ansprüche 1 bis 12, **dadurch gekennzeichnet, dass** sie aufweist:
den Hauptkörper (90) aufweisend die Aufnahmenut (901) und die Einkerbung (902); und
die Extraktionsvorrichtung (100), die lösbar in der Aufnahmenut (901) angeordnet ist.

## Revendications

1. Dispositif d'extraction (100), comprenant :
un boîtier (10) présentant une face avant qui comporte deux extrémités, l'une des deux extrémités comprenant un pivot (C), et une autre des deux extrémités comprenant un élément de limitation (30), l'élément de limitation (30) comportant au moins une partie en retrait de limitation (31) formée le long d'une direction de coulissement (D1) ;
une poignée (20) comportant une barre de traction (21) et un crochet (22), la barre de traction (21) comportant une extrémité de pivot (211) et une extrémité de manœuvre (212), l'extrémité de pivot (211) de la barre de traction (21) comportant une longue rainure (210) formée le long d'une direction longitudinale de la barre de traction (21), et une partie de traction et de préhension (213) étant formée sur l'extrémité de manœuvre (212) de la barre de traction (21), dans lequel la partie de traction et de préhension (213) est reliée au crochet (22), le pivot (C) du boîtier (10) est disposé dans la longue rainure (210) de la barre de traction (21), et une partie inférieure du crochet (22) est configurée pour venir en prise dans ladite au moins une partie en retrait de limitation (31) du boîtier (10) le long de la direction de coulissement (D1) afin d'être dans un état de mise en prise ;
dans lequel une extrémité avant du crochet (22) est configurée pour être simultanément bloquée au niveau d'un bord intérieur d'une encoche (902) d'un corps principal (90) d'un appareil électronique (9) dans l'état de mise en prise lorsque le dispositif d'extraction (100) est disposé de manière amovible dans une rainure de réception (901) du corps principal (90) de l'appareil électronique (9), de sorte que le crochet (22) est configuré pour fixer le dispositif d'extraction (100) dans l'encoche (902), l'encoche (902) servant d'entrée et de sortie de la rainure de réception (901) ;
dans lequel la poignée (20) est configurée pour coulisser sur une distance en ligne droite le long d'une direction de déverrouillage (D2), de sorte que le crochet (22), à l'état de mise en prise, s'éloigne de ladite au moins une partie en retrait de limitation (31) pour se trouver à un état de mise hors prise.

2. Dispositif d'extraction (100) selon la revendication 1, dans lequel la barre de traction (21) est réalisée en un matériau élastique, et un matériau du crochet (22) est différent de celui de la barre de traction (21), et dans lequel le crochet (22) est relié d'un seul tenant à la barre de traction (21).

3. Dispositif d'extraction (100) selon la revendication 1 ou 2, dans lequel le crochet (22) comporte une partie saillante supérieure (227) tournée vers la partie de traction et de préhension (213), et la partie de traction et de préhension (213) recouvre la partie saillante supérieure (227) ; dans lequel un trou de raccordement (228) est formé à une extrémité arrière du crochet (22), une partie inférieure de la partie de traction et de préhension (213) comporte une partie saillante inférieure (2133) qui s'étend vers le crochet (22), et la partie saillante inférieure (2133) s'étend dans le trou de raccordement (228).

4. Dispositif d'extraction (100) selon l'une des revendications 1 à 3, dans lequel la barre de traction (21) comporte une rainure (215) destinée à recevoir un doigt, formée sur l'un des deux côtés de la partie de traction et de préhension (213), et la barre de traction (21) comporte une saillie antidérapante (2132) formée sur un autre des deux côtés de la partie de traction et de préhension (213).

5. Dispositif d'extraction (100) selon l'une des revendications 1 à 4, dans lequel la barre de traction (21) comporte une rainure de positionnement (216) formée entre la longue rainure (210) et la partie de traction et de préhension (213) de la barre de traction (21) ; dans lequel le boîtier (10) comporte une partie de blocage (16), et la partie de blocage (16) est configurée pour bloquer la barre de traction (21), de sorte que la barre de traction (21) se trouve soit à l'état de mise en prise, soit à l'état de mise hors prise.

6. Dispositif d'extraction (100) selon l'une des revendications 1 à 5, dans lequel la partie de blocage (16) comporte un biseau de blocage (164), la rainure de positionnement (216) comporte un biseau de positionnement (2164), et le biseau de positionnement (2164) est proche du crochet (22) ; dans lequel, lorsque le crochet (22) passe de l'état de mise en prise à l'état de mise hors prise, le biseau de blocage (164) vient en butée contre le biseau de positionnement (2164).

7. Dispositif d'extraction (100) selon l'une des revendications 1 à 6, dans lequel le crochet (22) comporte une paroi supérieure (221) et une paire de parois latérales (222), chacune de parties inférieures de la paire de parois latérales (222) comporte un rail intérieur (223) s'étendant vers l'intérieur, et chacun de côtés intérieurs de la paire de parois latérales (222) est en retrait pour former une rainure de guidage (2220) située entre le rail intérieur (223) et la paroi supérieure (221) ; dans lequel chacun des deux côtés de l'élément de limitation (30) du boîtier (10) comporte l'une de ladite au moins une partie en retrait de limitation (31), et le rail intérieur (223) est configuré pour être disposé de manière coulissante dans la partie en retrait de limitation (31).

8. Dispositif d'extraction (100) selon la revendication 7, dans lequel le crochet (22) comporte une paroi arrière (224) ; dans lequel, lorsque le crochet (22) est à l'état de mise en prise, la paroi arrière (224) vient en butée contre l'élément de limitation (30).

9. Dispositif d'extraction (100) selon l'une des revendications 7 ou 8, dans lequel une fenêtre d'observation (2210) est formée sur la paroi supérieure (221) du crochet (22), et une partie supérieure de l'élément de limitation (30) est exposée à partir de la fenêtre d'observation (2210).

10. Dispositif d'extraction (100) selon l'une des revendications 7 ou 8, dans lequel la partie en retrait de limitation (31) comporte une partie convexe de blocage avant (311) et une partie convexe de blocage arrière (312), la partie convexe de blocage avant (311) est proche de l'une de deux extrémités de la partie en retrait de limitation (31), et la partie convexe de blocage arrière (312) est proche d'une autre des deux extrémités de la partie en retrait de limitation (31) ; dans lequel le rail intérieur (223) comporte un premier trou en retrait de positionnement (2231) et un deuxième trou en retrait de positionnement (2232).

11. Dispositif d'extraction (100) selon la revendication 10, dans lequel le deuxième trou en retrait de positionnement (2232) est situé en avant du premier trou en retrait de positionnement (2231) ; dans lequel, lorsque le crochet (22) est à l'état de mise en prise, la partie convexe de blocage arrière (312) vient en prise dans le premier trou en retrait de positionnement (2231) du crochet (22).

12. Dispositif d'extraction (100) selon l'une des revendications 1 à 11, dans lequel la barre de traction (21) comporte un bloc de positionnement en rotation (218), et le bloc de positionnement en rotation (218) fait saillie vers l'extérieur depuis une surface supérieure de l'extrémité de pivot (211) ; dans lequel, lorsque la barre de traction (21) est tournée d'un angle prédéterminé le long du pivot (C), la barre de traction (21) est bloquée sur le boîtier (10).

13. Appareil électronique (9) comportant un dispositif d'extraction (100) selon l'une quelconque des revendications 1 à 12, **caractérisé en ce qu'**il comprend :
le corps principal (90) comportant la rainure de réception (901) et l'encoche (902) ; et
le dispositif d'extraction (100) disposé de manière amovible dans la rainure de réception (901).
